# FASCICULE DE BREVET EUROPEEN

(11) **EP 0 656 591 B1**
(45) Date de publication et mention de la délivrance du brevet: **03.02.1999**
(21) Numéro de dépôt: 94402630.1
(22) Date de dépôt: 18.11.1994
(51) Int. Cl.: G06F 11/26

(54) **Simulateur de bus numérique intégré dans un système de test automatique**
Automatisches Testsystem mit integrierter Bussimulierung
ATE system with integrated bus simulation

(30) Priorité: 22.11.1993 FR 9313930
(43) Date de publication de la demande: 07.06.1995
(73) Titulaire: AEROSPATIALE Société Nationale Industrielle, 75781 Paris Cédex 16 (FR)
(72) Inventeur: Baraton, Jean-Yves, F-31820 Pibrac (FR); Rieusse, Jean-Pierre, F-82600 Verdun sur Garonne (FR); Sulmont, Benjamin, F-31300 Toulouse (FR)
(74) Mandataire: Dubois-Chabert, Guy

(56) Documents cités:
- AUTOTESTCON 90. IEEE SYSTEMS READINESS TECHNOLOGY CONFERENCE, 21 Septembre 1990, SAN ANTONIO, TX, USA pages 269 - 273 JOE BEAT 'ATE digital testing using a programmable microsequencer architecture'

## Description

### Domaine technique

La présente invention concerne un simulateur de bus numériques intégré dans un système de test automatique de boîtiers électroniques embarqués sur avion.

### Etat de la technique antérieure

Dans un avion, il existe différents systèmes, qui répondent à des fonctions précises : radar météorologique, traitement des paramètres de vol, génération électrique, etc... Ces systèmes sont composés de un ou plusieurs boîtiers électroniques qui sont reliés entre eux par des liaisons de communication que l'on appelle "Bus" et qui, dans le domaine aéronautique, sont décrits par des normes déposées chez ARINC (bureau de normalisation aéronautique). Ainsi par exemple, la norme ARINC 708 décrit le système radar météorologique, la norme ARINC 717 décrit le système d'acquisition des paramètres de vol. D'autres bus obéissent à des normes d'usage plus général (RS 232, 422 et 485 sont par exemple des standards publiés par l'organisme Electronic Industries Association), certains systèmes comportant de façon interne des bus qui sont propres à un fabricant de boîtier.

Un bus numérique est donc un moyen de transmission d'informations entre deux systèmes. L'information à transmettre est numérisée, et peut donc être représentée par une suite de 0 et de 1.

Les bus numériques se différencient principalement par les deux aspects suivants :
- le niveau physique qui concerne la nature des signaux mis en oeuvre et la façon de coder l'information binaire: par exemple un état 1 est représenté par une tension de 5 volts et un état 0 par une tension 0 volt ;
- le niveau protocole qui concerne des informations additionnelles ajoutées au message initial : elles permettent au système destinataire de recevoir l'information initiale avec le niveau de sécurité désiré, par exemple l'ajout d'un bit de parité qui est calculé à partir des informations binaires transmises.

Un système de test automatique destiné à la maintenance des boîtiers électroniques embarqués sur avion, permet de déterminer si un boîtier donné est opérationnel et si les bus numériques respectent toujours leurs spécifications d'origine.

Les fonctions suivantes sont nécessaires pour vérifier le bon fonctionnement d'un bus :
- génération d'informations sur le bus, conformément au protocole ;
- génération d'informations entachées d'erreur (non respect du protocole ou des tolérances sur les signaux), afin de vérifier le bon fonctionnement des organes de sécurisation du système sous test ;
- enregistrement des informations en provenance du système sous test, qui seront récupérées par le calculateur du système de test automatique et analysées par le programme test ;
- enregistrement des erreurs de protocole en provenance du système sous test ;
- génération de signaux de synchronisation afin d'effectuer des mesures en relation avec un événement sur le bus.

Pour effectuer la maintenance d'une flotte, une compagnie aérienne doit se doter d'un tel système de test automatique. Un système de cette nature doit être capable de recréer autour du boîtier à tester, un environnement identique à celui rencontré sur l'avion.

Pour effectuer le test de boîtiers embarqués sur avion, reliés par des bus numériques qui répondent à des standards différents, les systèmes de test automatique de l'art connu sont constitués en intégrant une multitude d'instruments de simulation, chacun étant dédié à un standard de bus.

Ces systèmes présentent donc de nombreux inconvénients et notamment :
- la multiplication du nombre d'instruments de simulation se traduit par une augmentation du coût du système de test (chaque instrument possède son propre coût de fabrication...) ;
- la fiabilité et le taux de disponibilité du système de test se dégradent si le nombre d'instruments augmente ;
- un système de test confronté, au cours de sa vie, à l'apparition sur le marché de nouveaux boîtiers possédant des bus non couverts par les instruments initiaux, doit nécessairement intégrer un instrument additionnel ;
- la taille du système de test est pénalisée par ce nombre d'instruments.
Le document Autotescon 90, IEEE SYSTEMS READINESS TECHNOLOGY CONFERENCE, pages 269-273, Joe Beat, 21 Sept. 90, San Antonio, US, définit de façon générale un émulateur de bus téléchargeable.

L'invention a pour objet un simulateur de bus numériques intégré dans un système de test automatique permettant d'effectuer, avec un seul instrument, la simulation de différents types de bus numériques d'un avion.

### Exposé de l'invention

La présente invention propose, à cet effet, un simulateur de bus numériques intégré dans un système de test automatique de boîtiers électroniques embarqués sur avion capable, afin de simuler les bus numériques utilisés sur l'avion, de se reconfigurer sous le contrôle d'un calculateur du système, par reconfiguration de son logiciel, caractérisé en ce qu'il est capable de se reconfigurer par reconfiguration de son matériel, en ce qu'il se présente sous la forme d'un seul instrument, et en ce qu'il comprend :
- un module interface de bus au standard VXI comprenant un premier microprocesseur assurant la communication avec le calculateur du système de test en respectant les protocoles de communication qui réalise l'interfaçage matériel avec un bus système au standard VXI ;
- une unité centrale application comprenant un deuxième microprocesseur assurant la gestion des bus mis en oeuvre et réalisant les fonctions de configuration et d'exploitation des bus à simuler;
- un module communications unité centrale qui comporte les circuits autorisant les échanges d'informations entre les premier et deuxième microprocesseurs du simulateur et avec le contrôleur du bus VXI ;
- un module de simulation d'application bus qui réalise les fonctions d'émission et de réception sur les bus simulés de façon autonome ainsi que la fonction de stockage des informations échangées ; ce module fonctionnel étant reconfigurable en fonction des bus à simuler ;
- un module interface analogique qui réalise l'adaptation matérielle analogique des bus simulés;
un premier bus véhiculant les signaux de déclenchement matériel entre le bus système au standard VXI et l'unité centrale application, un second bus véhiculant les signaux de déclenchement matériel entre l'unité centrale application, le module de simulation d'application bus, et le module interface analogique.

Avantageusement le logiciel et le matériel sont téléchargés.

Avantageusement cet instrument comporte une carte électronique dotée desdits deux microprocesseurs, de plusieurs banques mémoires, et de circuits logiques reconfigurables, le deuxième microprocesseur assurant la gestion des bus mis en oeuvre, en exécutant un logiciel applicatif téléchargé dans une première mémoire.

Une seconde mémoire étant accessible par le second microprocesseur et les automates. Dans les circuits configurables par mémoire volatile sont téléchargés les automates en logique câblée, nécessaires pour effectuer la simulation du bus. La logique nécessaire pour réaliser le contrôle de cette seconde mémoire étant également implémentée dans un circuit logique reconfigurable.

Le simulateur de bus numériques de l'invention est donc un instrument de simulation capable de se reconfigurer sous le contrôle du calculateur du système de test automatique (reconfiguration de son matériel et de son logiciel), afin de simuler de nombreux bus numériques utilisés sur avion.

Le simulateur de l'invention permet d'effectuer avec un seul instrument, la simulation de plusieurs bus différents (plusieurs standards différents peuvent être simulables par l'instrument).

En ne fabriquant qu'un seul instrument le coût du système est optimisé. Son encombrement est également optimisé. La fiabilité du système est améliorée, de plus la maintenance est facilitée ; les rechanges ne concernent plus qu'un seul instrument.

Le simulateur de l'invention permet de s'adapter à de nouveaux standards de bus, en ne modifiant que les informations de reconfiguration, téléchargées par le calculateur du système, cette intervention est sans commune mesure avec l'intégration d'un instrument de simulation additionnel.

Le module communications unité centrale comporte :
- une mémoire partagée au standard VXI ;
- une mémoire partagée double port ;
- un module événements asynchrones ;
- un module "chien de garde" ;
- un registre de contrôle ;

Ce module communication unité centrale contenant les éléments matériels permettant l'échange d'informations entre le bus système au standard VXI, le module interface de bus au standard VXI et l'unité centrale application.

L'unité centrale application comprend :
- une unité centrale ;
- une mémoire locale de travail ;
- un module horloge variable programmable ;
- un module traitement des exceptions ;
- un module horloge système, et ports divers ;
- un module gestion signaux de déclenchement matériel relié au premier et au second bus ;
une sortie de cette unité centrale étant reliée au module communications unité centrale et une autre sortie étant reliée au module de simulation d'application bus, cette unité centrale application fournissant les ressources matérielles nécessaires à l'exploitation des simulateurs de bus, ainsi que le processeur de bus qui assure l'exploitation des bus simulés.

Le module de simulation d'application bus comporte tout le matériel nécessaire pour effectuer les échanges d'informations sur les bus simulés, de façon autonome et comprend :
- un module isolation de bus, décodage bus reconfigurable par mémoire volatile (LCA), et registres simulateurs ;
- un module contrôleur DMA et d'horloge datation ;
- un module de simulation bus reconfigurables ;
- une mémoire d'échange ;
- un module translateur bus de données ;
- des périphériques spécialisés ;
- des circuits adaptation de ligne ;
les entrées et sorties de ce module d'application bus étant reliées respectivement au module unité centrale application, au second bus des signaux de déclenchement matériel et à la carte interface analogique, la dernière sortie délivrant les signaux bus simulés.

### Brève description des dessins

- La figure 1 illustre un système de test automatique de l'art connu ;
- les figures 2 à 5 illustrent un exemple de réalisation du simulateur de bus numériques de l'invention.

### Exposé détaillé de modes de réalisation

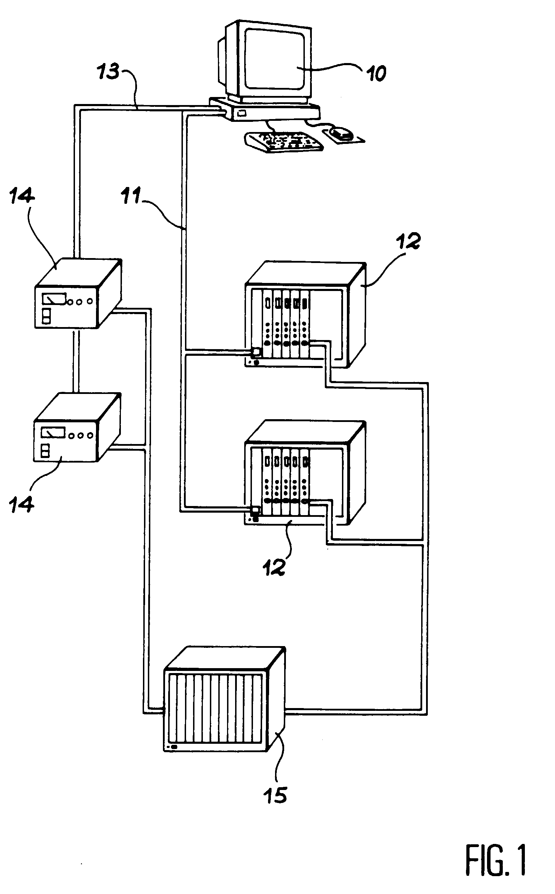

Comme représenté sur la figure 1, un système de test automatique comprend notamment :
- un calculateur 10 : ce calculateur est doté d'un logiciel, qui permet de développer et d'exécuter les programmes de test. Il est relié à l'instrumentation qu'il pilote via un ou plusieurs bus systèmes ;
- des bus systèmes 11, 13 : le calculateur 10 du système de test dialogue avec l'instrumentation 12, 14 via plusieurs bus par exemple les bus suivants :
   - un bus MXI 11 : bus développé par National Instrument, et conçu pour relier plusieurs châssis VXI 12 entre eux, et avec différents types de calculateur,
   - un bus IEEE 488 13 : bus standard pour communiquer avec de l'instrumentation 14 ;
- des modules instrumentation 12, 14 : les instruments intégrés sur le système de test sont pour la plupart au standard VXI (extension du bus VME pour l'instrumentation). Ces instruments se présentent sous la forme de cartes électroniques, ou éventuellement sous la forme traditionnelle d'instruments de laboratoire ;
- un module commutation 15 : la commutation répond par exemple au standard ARINC 608 ; elle permet d'aiguiller les signaux, en provenance du boîtier sous test, vers l'instrumentation du système.

Le système de test automatique défini ci-dessus comporte un simulateur de bus numériques.

Les différents bus numériques utilisés sur avion différent par les caractéristiques physiques du signal (tension, fréquence...) et par le protocole utilisé (constitution des trames d'information binaire...). Certaines caractéristiques sont contrôlables par un microprocesseur ; les trames du système ARINC 708 sont par exemple générées avec un intervalle de temps de 7.82 ms. Pour ces caractéristiques l'adaptation à un nouveau type de bus suppose de changer le logiciel applicatif de l'instrument, en fonction du bus à simuler. Certaines caractéristiques sont contrôlables par un automate réalisé en logique câblée (par exemple les informations binaires présentes sur le bus WXR sont émises au débit de huit millions d'informations par seconde). Pour ces caractéristiques l'adaptation à un nouveau type de bus suppose de changer la logique câblée de l'automate.

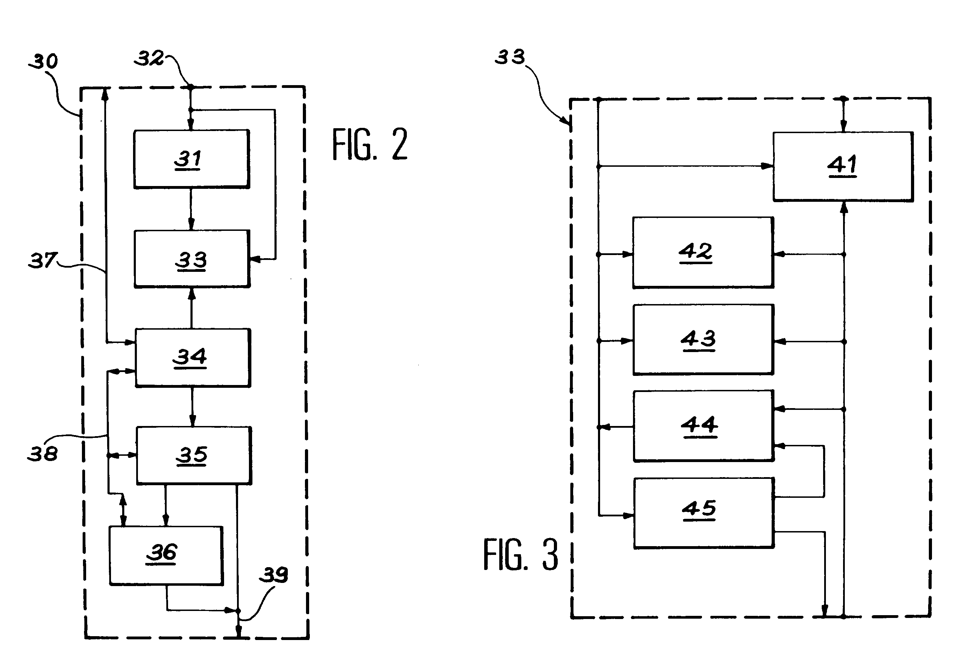

Dans le cadre de l'invention le simulateur de bus numériques, tels que représenté à la figure 2, comporte une carte électronique 30, dotée de deux microprocesseurs, de plusieurs banques mémoires et de circuits logiques reconfigurables.

Le premier microprocesseur est intégré dans un module interface 31. Le second microprocesseur est intégré dans un module unité centrale 34. Les banques mémoires sont réparties dans le module interface 31 et dans les modules communication unité centrale 33, unité centrale application 34, et simulation bus 35.

Le premier microprocesseur assure la communication avec le calculateur du système de test en respectant des protocoles de communication, par exemple ceux définis par le standard VXI.

Le deuxième microprocesseur assure la gestion des bus mis en oeuvre, en exécutant le logiciel applicatif téléchargé dans une première mémoire.

Le premier module 31 reçoit les signaux d'un bus 32, par exemple de type VXI. Un module interface analogique 36 permet de délivrer des signaux bus simulés 39.

Des automates en logique câblée, nécessaires pour effectuer la simulation du bus, sont téléchargés dans le module 35. Ils sont par exemple de type FPGA (Field Programmable Gate Array) configurables par mémoire volatile (composant LCA "Logic Cell Array" fabriqué par XILINX).

Une seconde mémoire est accessible par le second microprocesseur. Les automates sont réalisés en logique câblée. La logique nécessaire pour réaliser le contrôle de cette mémoire (circuit DMA) est également implémentée dans un circuit logique reconfigurable. Cette reconfiguration des mécanismes de gestion interne du simulateur de bus est nécessaire pour s'adapter aux exigences de vitesse spécifiques à chaque bus numérique simulé. (Par exemple quand le simulateur de bus est utilisé pour simuler plusieurs bus RS 232, il faut télécharger un circuit DMA capable de gérer 8 canaux avec un temps de cycle de 800 nanosecondes. Quand le simulateur de bus est utilisé pour simuler un bus WXR, il faut télécharger un circuit DMA avec un temps de cycle de 200 ns).

L'architecture du simulateur de bus numériques permet de télécharger dans celui-ci le logiciel applicatif, et la logique câblée des automates, permettant d'effectuer la simulation d'un nouveau bus numérique.

Avantageusement le simulateur de bus numériques de l'invention est une carte répondant au standard VXI (VMEbus Xtensions for Instrumentation) capable de simuler les bus numériques RS 232, RS 422, RS 485, ARINC 708, ARINC 717, DSDL, WXR, IO discrets sur deux voies simultanément.

Pour réaliser un automate en logique câblée sur une carte électronique, il existe de nombreuse façon de procéder : par exemple par un assemblage de boîtiers assurant les fonctions logiques élémentaires et relier ces boîtiers par les pistes du circuit imprimé.

Les besoins d'intégration augmentent, aussi on cherche à intégrer cette logique à l'intérieur de circuits de type PAL, GATE ARRAY, FPGA ou ASIC. Toutes ces familles de circuits intégrés sont destinées à permettre l'intégration d'une fonction logique définie par l'utilisateur. De tels circuits différent par la complexité de la fonction que l'on peut intégrer (nombre de portes équivalentes), la vitesse de fonctionnement, le mode de "programmation" permettant de "graver" la fonction dans le circuit intégré (exemple : pour les plus complexes, les ASlCS, il faut faire appel à un fondeur de silicium).

Les circuits intégrés de type FPGA configurables par mémoire volatile sont structurés de la façon suivante. Ils possèdent des blocs logiques configurables et des moyens pour relier ces blocs entre eux. De plus, ils disposent d'une mémoire de configuration, dont le contenu détermine les équations logiques de chaque bloc, les liaisons entre blocs, et les liaisons avec les entrées sorties du circuit. Il est donc possible d'établir la correspondance entre un contenu de la mémoire de configuration et une fonction logique (automate) remplie par le circuit intégré.

Si l'on considère à présent la mise en oeuvre du système de test automatique contenant le simulateur de bus de l'invention : le calculateur du système de test automatique exécute un programme de test. Ce programme met en oeuvre la simulation d'un bus numérique particulier. Le calculateur possède dans sa mémoire de masse, un ensemble de fichiers. Chaque fichier représente le contenu de la mémoire de configuration du circuit FPGA, et est associé à un automate. En fonction du bus à simuler, le calculateur établit la configuration du simulateur de bus avec l'ensemble de fichiers correspondant.

Un protocole de communication entre le simulateur de bus et le calculateur du système de test est défini pour que ce fichier soit communiqué au microprocesseur de ce sous-système qui est en relation directe avec le circuit FPGA. Ce microprocesseur reçoit l'ordre de configurer le circuit FPGA ; il effectue alors une séquence spécifique au téléchargement (cette séquence est décrite dans la documentation du composant). Il utilise les entrées sorties du circuit FPGA prévues pour cette fonction et transfère dans la mémoire de configuration les données du fichier. Quand toutes les données ont été transférées, le circuit FPGA passe en mode opérationnel et remplit sur ses entrées sorties, la fonction logique définie par sa mémoire de configuration.

Dans un exemple de réalisation, comme représenté à la figure 2, le simulateur de bus numériques de l'invention est composé en plusieurs modules :
- un module interface bus VXI 31 qui réalise l'interfaçage matériel avec un bus VXI 32. Ce module est réalisé autour d'un module DT9150 du fabricant Interface Technology qui est doté d'un microprocesseur 68000 ;
- un module communications unité centrale 33 qui comporte les circuits autorisant les échanges d'informations entre les deux processeurs du simulateur et avec le contrôleur du bus VXI ;
- une unité centrale application 34 qui est architecturée autour d'un microprocesseur 68020, ce module réalisant les fonctions de configuration et d'exploitation des bus à simuler ;
- un module 35 de simulation de bus qui réalise les fonctions d'émission et de réception sur les bus simulés de façon autonome ainsi que la fonction de stockage des informations échangés ; ce module fonctionnel est reconfigurable en fonction des bus à simuler ;
- un module interface analogique 36 qui réalise l'adaptation matérielle analogique des bus A717, A708, WXR et DSDL. Il consiste en une carte qui se connecte sur la carte principale du simulateur de bus par l'intermédiaire de plusieurs connecteurs.

Un premier bus 37 dit "TTL Trigger" véhicule les signaux de déclenchement matériel entre le bus VXI et l'unité centrale application 34.

Un second bus 38 dit "Trigger" véhicule les signaux de déclenchement matériel entre l'unité centrale application 34, le module 35 de simulation d'application bus, et le module 36 interface analogique.

Comme représenté sur la figure 3, le module communications unité centrale 33 comporte :
- une mémoire partagée VXI 41, de 64 K x 16 bits ;
- une mémoire partagée double port 42, de 2K x16 bits ;
- un module événements asynchrones 43 (basé par exemple sur un circuit de type 68901) ;
- un module "chien de garde" 44 par exemple un circuit MAX 699 CPA ;
- un registre de contrôle 45 (initialisation du module unité centrale 34, gestion du "chien de garde").

Ce module 33 contient les éléments matériels permettant l'échange d'informations entre le bus VXI, le module interface VXI et l'unité centrale application.

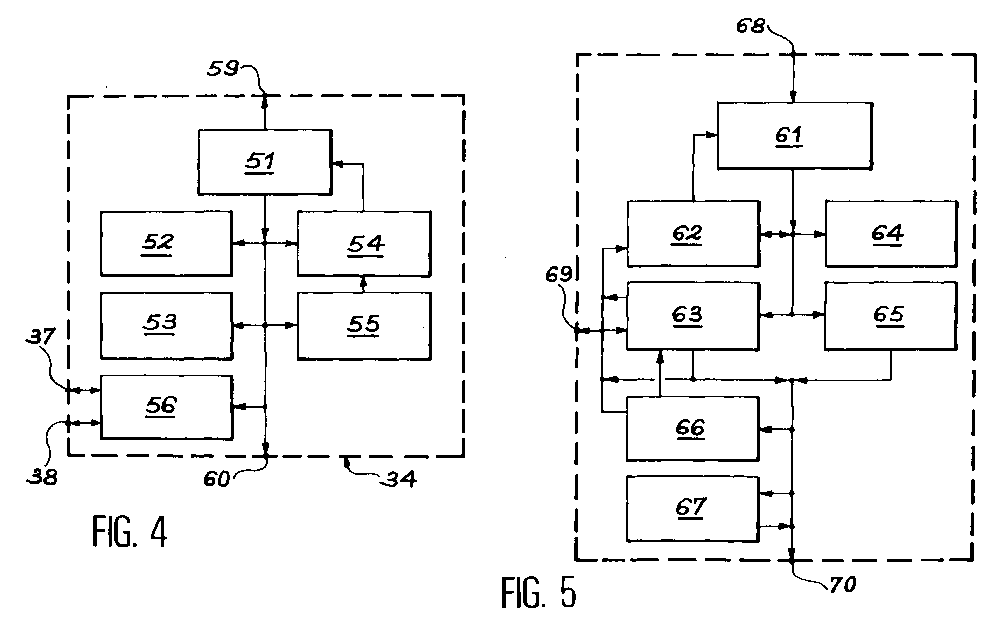

L'unité centrale application, telle que représentée à la figure 4, comprend :
- une unité centrale 51 (par exemple un microprocesseur de type 68020) et sa logique de décodage (basé sur PAL 22V10) ;
- une mémoire locale de travail 52, de 256 K x 32 bits ;
- un module horloge variable programmable 53 (par exemple un circuit FPGA XC3090 associé à des oscillateurs contrôlés en tension) ;
- un module traitement des exceptions 54 ;
- un module horloge système 55, et ports divers, basé sur un circuit MC 68901 ;
- un module gestion signaux de déclenchement matériel 56 (par exemple un circuit FPGA XC3090), relié à deux bus : au premier bus 37 dit "TTL Trigger" et au second bus 38 dit "Trigger".

La sortie 59 est reliée au module communications unité centrale 33 et la sortie 60 est reliée au module de simulation application bus 35.

Cette unité centrale application fournit les ressources matérielles nécessaires à l'exploitation des simulateurs de bus, ainsi que le processeur de bus qui assure l'exploitation des bus simulés.

Le module de simulation de bus numérique 35, tel que représenté sur la figure 5, comporte tout le matériel nécessaire pour effectuer les échanges d'informations sur les bus simulés, de façon autonome (sans intervention du microprocesseur 68020).

Il comprend :
- un module 61 isolation bus, décodage bus LCA, et registres simulateurs ;
- un module 62 contrôleur DMA et d'horloge datation, par exemple un circuit FPGA XC4005 ;
- un module 63 de simulation bus reconfigurables, par exemple deux circuits FPGA XC4005 ;
- une mémoire d'échange 64, de 256 K x 32 bits ;
- un module 65 translateur bus de données ;
- des périphériques spécialisés SCC ("Serial Communication Controller") 66, par exemple ZC 16C30 ;
- des circuits adaptation de ligne 67 (RS, entrée/sortie).

Ses entrées et sorties 68, 69 et 70 sont reliées respectivement au module unité centrale application, au bus "Trigger" et à la carte interface analogique, cette dernière sortie délivrant les signaux bus simulés.

Ce module est conçu à partir de trois circuits reconfigurables, dont un assure la fonction contrôleur de DMA, les deux autres sont configurés indépendamment pour gérer les bus à simuler. Il comporte une mémoire recevant les informations échangées sur les bus simulés et deux circuits spécialisés pour la gestion des bus série type RS 232.

Les circuits de ce module sont interfacés à un bus, contrôlé par le circuit DMA dès que ce dernier est configuré. Les automates de simulation des bus demandent au circuit DMA d'assurer le transfert des données tant en émission qu'en réception. Ensuite l'automate assure de façon autonome le couplage au bus simulé.

La programmation des paramètres nécessaires à chaque automate de gestion du bus simulé est assuré par l'unité centrale application, qui demande le contrôle du bus au circuit DMA, pour effectuer ces opérations.

## Revendications

1. Simulateur de bus numériques intégré dans un système de test automatique de boîtiers électroniques embarqués sur avion capable, afin de simuler les bus numériques utilisés sur l'avion, de se reconfigurer sous le contrôle d'un calculateur du système, par reconfiguration de son logiciel, caractérisé en ce qu'il est capable de se reconfigurer par reconfiguration de son matériel, en ce qu'il se présente sous la forme d'un seul instrument, et en ce qu'il comprend :
- un module interface de bus au standard VXI (31) comprenant un premier microprocesseur assurant la communication avec le calculateur du système de test en respectant les protocoles de communication qui réalise l'interfaçage matériel avec un bus système au standard VXI (32) ;
- une unité centrale application (34) comprenant un deuxième microprocesseur assurant la gestion des bus mis en oeuvre et réalisant les fonctions de configuration et d'exploitation des bus à simuler ;
- un module communications unité centrale (33) qui comporte les circuits autorisant les échanges d'informations entre les premier et deuxième microprocesseurs du simulateur et avec le contrôleur du bus VXI (32);
- un module (35) de simulation d'application bus qui réalise les fonctions d'émission et de réception sur les bus simulés (39) de façon autonome ainsi que la fonction de stockage des informations échangées ; ce module fonctionnel étant reconfigurable en fonction des bus à simuler ;
- un module interface analogique (36) qui réalise l'adaptation matérielle analogique des bus simulés,
un premier bus (37) véhiculant les signaux de déclenchement matériel entre le bus système au standard VXI et l'unité centrale application (34), un second bus (38) véhiculant les signaux de déclenchement matériel entre l'unité centrale application (34), le module (35) de simulation d'application bus, et le module (36) interface analogique.

2. Simulateur selon la revendication 1, caractérisé en ce que le logiciel et le matériel sont téléchargés.

3. Simulateur selon la revendication 1, caractérisé en ce que cet instrument comporte une carte électronique (30) dotée desdits deux microprocesseurs, de plusieurs banques mémoires, et de circuits reconfigurables; le deuxième microprocesseur assurant la gestion des bus mis en oeuvre, en exécutant un logiciel applicatif téléchargé dans une première mémoire, et une seconde mémoire étant accessible par le second microprocesseur, la logique nécessaire pour réaliser le contrôle de cette seconde mémoire étant implémentée dans un circuit logique reconfigurable.

4. Simulateur selon la revendication 3, caractérisé en ce que les automates en logique câblée, nécessaires pour effectuer la simulation de bus, sont téléchargés dans des circuits configurables par mémoire volatile.

5. Simulateur selon la revendication 1 caractérisé en ce que le module communications unité centrale (33) comporte :
- une mémoire partagée au standard VXI (41) ;
- une mémoire partagée double port (42) ;
- un module événements asynchrones (43) ;
- un module "chien de garde" (44) ;
- un registre de contrôle (45) ;
ce module communications unité centrale (33) contenant les éléments matériels permettant l'échange d'informations entre le bus système au standard VXI (32), le module interface de bus au standard VXI (31) et l'unité centrale application (34).

6. Simulateur selon la revendication 1, caractérisé en ce que l'unité centrale application comprend :
- une unité centrale (51) ;
- une mémoire locale de travail (52) ;
- un module horloge variable programmable (53) ;
- un module traitement des exceptions (54) ;
- un module horloge système (55), et ports divers ;
- un module gestion signaux de déclenchement matériel (56) relié au premier et au second bus (37, 38) ;
une sortie (59) de cette unité centrale (34) étant reliée au module communications unité centrale (33) et une autre sortie (60) étant reliée au module de simulation d'application bus (35), cette unité centrale application fournissant les ressources matérielles nécessaires à l'exploitation des simulateurs de bus, ainsi que le processeur de bus qui assure l'exploitation des bus simulés.

7. Simulateur selon la revendication 1, caractérisé en ce que le module de simulation d'application de bus (35) comporte tout le matériel nécessaire pour effectuer les échanges d'informations sur les bus simulés, de façon autonome, et comprend :
- un module (61) isolation de bus, décodage bus reconfigurable par mémoire volatile (LCA), et registres simulateurs ;
- un module (62) contrôleur DMA et d'horloge datation ;
- un module (63) de simulation de bus reconfigurables ;
- une mémoire d'échange (64) ;
- un module (65) translateur bus de données ;
- des périphériques spécialisés (66) ;
- des circuits adaptation de ligne (67) ;
les entrées et sorties (68, 69 et 70) de ce module d'application de bus (35) étant reliées respectivement au module unité centrale application (34), au second bus (38) des signaux de déclenchement matériel et à la carte interface analogique (36), la dernière sortie délivrant les signaux bus simulés.

## Patentansprüche

1. Integrierter Bussimulator in einem automatischen Testsystem für elektronische Geräte, die in einem Flugzeug angeordnet sind, der zur Simulation der in dem Flugzeug verwendeten Bussysteme in der Lage ist, sich unter der Steuerung eine Systemrechners durch Rekonfiguration seiner Software zu rekonfigurieren, dadurch gekennzeichnet, daß er in der Lage ist, sich durch Rekonfiguration seiner Hardware zu rekonfigurieren, daß er sich in der Form eines einzigen Instruments darstellt und daß er umfaßt:
- einen Schnittstellenmodul für den Bus des Standards VXI (31), der einen ersten Mikroprozessor umfaßt, der die Kommunikation mit dem Testsystemrechner sicherstellt, wobei er die Kommunikationsprotokolle berücksichtigt, und die Hardwareschnittstelle mit einem Systembus des Standards VXI (32) bildet;
- eine zentrale Betriebseinheit (34), die einen zweiten Mikroprozessor umfaßt, der den Betrieb der verwendeten Bussysteme sicherstellt und die Funktionen der Konfiguration und der Auswertung der zu simulierenden Bussysteme durchführt;
- einen Zentraleinheits-Kommunikationsmodul (33), der die Schaltkreise umfaßt, die den Informationsaustausch zwischen dem ersten und dem zweiten Mikroprozessor und dem Kontroller des Buses VXI (32) ermöglichen;
- einen Modul (35) zur Busbetriebssimulation, der die Sende- und Empfangsfunktionen der simulierten Bussysteme (39) autonom durchführt und auch die Funktion der Speicherung der ausgetauschten Informationen durchführt; wobei dieser Modul in Abhängigkeit von den zu simulierenden Bussystemen rekonfigurierbar ist;
- einen analogen Schnittstellenmodul (36), der die analoge Hardwareanpassung der simulierten Bussysteme durchführt,
wobei ein erster Bus (37) die Hardwareauslösesignale zwischen dem Bussystem des Standards VXI und der zentralen Betriebseinheit (34) überträgt und ein zweiter Bus (38) die Hardwareauslösesignale zwischen der zentralen Betriebseinheit (34), dem Modul (35) zur Busbetriebssimulation und dem analogen Schnittstellenmodul (36) überträgt.

2. Simulator nach Anspruch 1, dadurch gekennzeichnet, daß die Software und die Hardware ferngeladen werden.

3. Simulator nach Anspruch 1, dadurch gekennzeichnet, daß dieses Instrument eine elektronische Karte (30) umfaßt, die mit den beiden Mikroprozessoren, mehreren Speicherbänken und rekonfigurierbaren Schaltkreisen ausgestattet ist; wobei der zweite Mikroprozessor den Betrieb der in Betrieb genommenen Bussysteme sicherstellt, indem er eine in einen ersten Speicher ferngeladene Anwendungssoftware ausführt, und der zweite Mikroprozessor auf einen zweiten Speicher zugreifen kann, wobei die für die Steuerung des zweiten Speichers notwendige Logik in einem rekonfigurierbaren Logikschaltkreis implementiert ist.

4. Simulator nach Anspruch 3, dadurch gekennzeichnet, daß die Automaten mit verdrahteter Logik, die zum Durchführen der Bussimulation notwendig sind, in durch flüchtige Speicher konfigurierbare Schaltkreise ferngeladen werden.

5. Simulator nach Anspruch 1, dadurch gekennzeichnet, daß der Zentraleinheits-Kommunikationsmodul (33) umfaßt:
- einen geteilten Speicher des Standards VXI (41);
- einen geteilten Speicher (42) mit doppeltem Anschluß;
- einen Modul (43) für asynchrone Ereignisse (43);
- einen "Wachhund-" Modul (44);
- ein Steuerungsregister (45);
wobei der Zentraleinheits-Kommunikationsmodul (33) die Hardwareelemente umfaßt, die den Informationsaustausch zwischen dem Systembus des Standards VXI (32), dem Schnittstellenmodul des Busses des Standards VXI (31) und der zentralen Betriebseinheit (34) ermöglichen.

6. Simulator nach Anspruch 1, dadurch gekennzeichnet, daß die zentrale Betriebseinheit umfaßt:
- eine Zentraleinheit (51);
- einen lokalen Arbeitsspeicher (52);
- einen variablen, programmierbaren Taktmodul (53);
- einen Modul (54) zur Verarbeitung der Ausnahmen;
- einen Systemtaktmodul (55) und verschiedene Anschlüsse;
- einen Verarbeitungsmodul (56) für Auslösesignale, der mit dem ersten und dem zweiten Bus (37, 38) verbunden ist,
wobei ein Ausgang (59) der zentralen Einheit (34) mit dem Zentraleinheits-Kommunikationsmodul (33) verbunden ist und ein weiterer Ausgang (60) mit dem Modul (35) zur Busbetriebssimulation verbunden ist, wobei die zentrale Betriebseinheit die Hardwarevorraussetzungen bietet, die zur Auswertung der Bussimulatoren notwendig sind, sowie den Busprozessor umfaßt, der die Auswertung der simulierten Bussysteme sicherstellt.

7. Simulator nach Anspruch 1, dadurch gekennzeichnet, daß der Modul (35) zur Busbetriebssimulation die gesamte Hardware umfaßt, die zum autonomen Austausch von Informationen zwischen den simulierten Bussystemen notwendig ist, und umfaßt:
- einen Modul (61) zur Busisolation, zur durch einen flüchtigen Speicher rekonfigurierbaren Busdekodierung (LCA) und Simulationsregister;
- einen Modul (62) zur DMA-Steuerung und zur Datierung;
- einen Modul (63) zur Simulation von rekonfigurierbaren Bussystemen;
- einen Austauschspeicher (64);
- einen Übersetzungsdatenbusmodul (65);
- spezialisierte Peripherie (66);
- Leitungsanpassungsschaltkreise (67);
wobei die Eingänge und Ausgänge (68, 69 und 70) des Busbetriebsmoduls (35) jeweils mit dem Zentraleinheits-Betriebsmodul (34), dem zweiten Bus (38) für Hardwareauslösesignale und der analogen Schnittstellenkarte (36) verbunden sind, wobei der letzte Ausgang die simulierten Bussignale liefert.

## Claims

1. Digital bus simulator integrated into an automatic system for the testing of electronic packages carried on an aircraft and which, in order to be able to simulate the digital buses used on the aircraft, to be reconfigured under the control of a computer of the system, by reconfiguration of its software, characterized in that it can be reconfigured by reconfiguring its hardware, in that it is in the form of a single instrument and in that it comprises:
- an interface bus module (31) to standard VXI having a first microprocessor ensuring the communication with the test system computer, whilst respecting communication protocols, which effects the hardware interfacing with a VXI standard bus system (32),
- an application central processing unit (34) having a second microprocessor for controlling the buses used and performing configuration and exploitation functions of the buses to be simulated,
- a central processing unit communications module (33) having circuits authorizing information exchanges between the first and second microprocessors of the simulator and with the VXI bus controller (32),
- a bus application simulation module (35), which performs the transmission and reception functions on the autonomously simulated buses (39), as well as the exchanged information storage function, said functional module being reconfigurable as a function of the buses to be simulated,
- an analog interface module (36) effecting the analog hardware matching of the simulated buses,
a first bus (37) carrying the hardware triggering signals between the standard VXI system bus and the application central processing unit (34), a second bus (38) carrying the hardware triggering signals between the application central processing unit (34), the bus application simulation module (35) and the analog interface module (36).

2. Simulator according to claim 1, characterized in that the software and hardware are downloaded.

3. Simulator according to claim 1, characterized in that said instrument incorporates an electronic card (30) having said two microprocessors, several memory banks and reconfigurable circuits, the second microprocessor ensuring the control of the buses used, by effecting an applicative software downloaded in a first memory, a second memory being accessible by the second microprocessor, the necessary logic for checking said second memory being implemented in a reconfigurable logic circuit.

4. Simulator according to claim 3, characterized in that the cabled logic controllers, necessary for performing the bus simulation, are downloaded in circuits configurable by volatile memory.

5. Simulator according to claim 1, characterized in that the central processing unit communications module (33) comprises:
- a standard VXI shared memory (41),
- a double port shared memory (42),
- an asynchronous events module (43);
- a "watchdog" module (44),
- a control register (45),
said central unit communications module (33) containing hardware elements permitting the exchange of informations between the VXI standard bus system (32), the VXI standard bus interface module (31) and the application central processing unit (34).

6. Simulator according to claim 1, characterized in that the application central processing unit incorporates:
- a central processing unit (51),
- a local working memory (52),
- a programmable, variable clock module (53),
- a module for processing exceptions (54),
- a system clock module (55) and various ports,
- a hardware triggering signal control module (56) connected to the first and second buses (37, 38),
an output (59) of said central processing unit (540 being connected to the central unit communications module (33) and another output (60) being connected to the bus application simulation module (35), said application central processing unit supplying the hardware resources necessary for the exploitation of the bus simulators, as well as the bus processor ensuring the exploitation of the simulated buses.

7. Simulator according to claim 1, characterized in that the bus application simulation module (34) has all the hardware necessary for effecting the information exchanges on the simulated buses in an autonomous manner and comprises:
- a bus isolation module (61), a volatile memory reconfigurable (LCA) bus decoding module and simulator registers,
- a DMA and dating clock controller module (62),
- a reconfigurable bus simulation module (63),
- an exchange memory (64),
- a data bus translator module (65),
- specialized peripheral units (66),
- line matching circuits (67),
the inputs and outputs (68, 69, 70) of said bus application module (35) being respectively connected to the application central processing unit module (34), to the second hardware triggering signal bus (38) and to the analog interface card (36), the last output supplying the simulated bus signals.
